# EUROPEAN PATENT APPLICATION

(11) **EP 2 750 188 A2**
(43) Date of publication of application: **02.07.2014**
(21) Application number: 13158976.4
(22) Date of filing: 13.03.2013
(51) Int. Cl.: H01L 25/075

(54) **Light-emitting module board and manufacturing method of the light-emitting module board**

(30) Priority: 28.12.2012 JP 2012287802
(71) Applicant: Toshiba Lighting & Technology Corporation, Yokosuka-shi Kanagawa 237-8510 (JP)
(72) Inventor: Ueno, Kousuke, Kanagawa, 237-8510 (JP); Shibano, Nobuo, Kanagawa, 237-8510 (JP); Takahara, Yuichiro, Kanagawa, 237-8510 (JP); Tamai, Hiroki, Kanagawa, 237-8510 (JP); Hamasaki, Hiroshi, Kanagawa, 237-8510 (JP)
(74) Representative: Bokinge, Ole

(57) **Abstract**

A light-emitting module board (1) includes a metal board (11) provided with an insulating layer (12), a light-emitting part (51) and a white insulating film (14B). The light-emitting part (51) includes plural LED chips (16) mounted on the metal board (11), and a white reflecting film (14A) of a ceramic coating formed in a light-emitting area on the metal board (11) on which the plural LED chips (16) are mounted. The white insulating film (14B) is an insulating film made of a same material as the white reflecting film (14A) and formed in a non-light-emitting area which is other than the light-emitting part (51) and is provided on the metal board (11) outside the light-emitting part (51).

## Description

### FIELD

Embodiments described herein relate generally to a light-emitting module board and a manufacturing method of the light-emitting module board.

### BACKGROUND

In recent years, the COB (Chip On Board) type in which light-emitting components, such as plural LED (Light Emitting Diode) chips, are mounted on a board is known as a light-emitting module. A light-emitting module board of the COB type light-emitting module is such a board that an insulating layer is formed on a metal board on which the light-emitting components are mounted, a resist layer is formed on the insulating layer, and a ceramic ink film of a white reflecting film is formed on the resist layer.

However, in the light-emitting module board, since the ceramic ink film is made of a material different from the resist layer formed on the board on which the light-emitting components are mounted, the manufacture can become complicated.

According to an exemplary embodiment, a light-emitting module board and a manufacturing method of the light-emitting module board are provided, in which not only a mounting area but also a light-emitting module board can be easily formed.

### DESCRIPTION OF THE DRAWINGS

FIG. 1 is a substantially vertical sectional view showing an example of a light-emitting module board of a first embodiment.
FIG. 2 is a plan view showing an example of the light-emitting module board.
FIG. 3 is a substantially sectional view schematically showing an example of the light-emitting module board.
FIG. 4 is a substantially sectional view schematically showing reference example 1 of a light-emitting module board.
FIG. 5A is an explanatory view showing a manufacturing process of the light-emitting module board shown in FIG. 4
FIG. 5B is an explanatory view showing a manufacturing process of the light-emitting module board shown in FIG. 3.
FIG. 6 is a substantially sectional view schematically showing reference example 2 of a light-emitting module board.
FIG. 7 is a substantially sectional view schematically showing an example of a light-emitting module board of a second embodiment.
FIG. 8 is an explanatory view showing a manufacturing process of the light-emitting module board shown in FIG. 7.

### DETAILED DESCRIPTION

Hereinafter, light-emitting module boards and manufacturing methods of the light-emitting module boards according to exemplary embodiments will be described with reference to the drawings. In the respective embodiments, the same components are denoted by the same reference numerals and the description of the duplicate components and operations will be omitted. Incidentally, the light-emitting module boards and the manufacturing methods of the light-emitting module boards described in the following embodiments are merely exemplary, and are not intended to limit the invention. Besides, the following embodiments may be appropriately combined within the consistent range.

According to one embodiment, a light-emitting module board includes a board, a light-emitting part and a white insulating film. The light-emitting part includes plural light-emitting components mounted on the board, and a white reflecting film of a ceramic coating formed in a light-emitting area on the board on which the plural light-emitting components are mounted. The white insulating film is made of a same material as the white reflecting film and is formed in a non-light-emitting area which is other than the light-emitting part and is provided on the board outside the light-emitting part. That is, in the light-emitting module board of the embodiment, not only the light-emitting area as the mounting area but also the light-emitting module board can be easily formed. Further, degradation of the insulation film as a solder resist of the non-light-emitting area due to a difference in curing temperature between the reflecting film and the insulating film can be suppressed.

In the light-emitting module board of the embodiment, a wiring pattern is formed in the light-emitting area and the non-light-emitting area, and a protecting layer is formed in the non-light-emitting area and in a wiring area for electrically connecting the light-emitting components to an external wiring. That is, in the light-emitting module board of the embodiment, since the protecting layer is formed in the wiring area for electrically connecting the light-emitting components to the external wiring, the protecting layer can suppress the corrosion of the wiring pattern due to the white insulating film.

In the light-emitting module board of the embodiment, the protecting layer formed in the wiring area is made of a same component as that of a metal plating formed on the wiring pattern for electrical connection with the plural light-emitting components formed in the light-emitting area. That is, in the light-emitting module board of the embodiment, the protecting layer is made to have the same component as the metal plating formed on the wiring pattern, the manufacturing process of forming the protecting layer and the metal plating layer is sufficient to be performed once.

In the light-emitting module board of the embodiment, the protecting layer formed in the wiring area is made of a component different from that of a metal plating formed on the wiring pattern for electrical connection with the plural light-emitting components formed in the light-emitting area. That is, in the light-emitting module board of the embodiment, the component of the protecting layer of the wiring area can be changed according to the use.

The white reflecting film formed in the light-emitting area of the light-emitting module board of the embodiment includes a first white reflecting film and a second white reflecting film formed on the first white reflecting film. That is, in the light-emitting module board of the embodiment, since the second white reflecting film is formed on the first white reflecting film, the light from the light-emitting components is diffusely reflected by the first white reflecting film and the second white reflecting film. Accordingly, the light extraction efficiency is improved, and the illumination performance is improved.

The ceramic coating of the light-emitting module board of the embodiment contains at least metal oxide and silicone. As a result, peeling of the white reflecting film can be suppressed.

The board of the light-emitting module board of the embodiment includes a metal board and an insulating layer laminated on the metal board. As a result, the board including the insulating layer can be provided.

A manufacturing method of a light-emitting module board of the embodiment includes forming a wiring pattern on a board, and forming a white reflecting film in a light-emitting area and forming a white insulating film in a non-light-emitting area by applying a ceramic coating to the light-emitting area on the board on which plural light-emitting components are mounted and to the non-light-emitting area on the board outside the light-emitting area and by performing a thermosetting process. That is, in the manufacturing method of the light-emitting module board of the embodiment, not only the light-emitting area as the mounting area but also the light-emitting module board can be easily formed. Further, degradation of the insulation film as a solder resist of the non-light-emitting area due to a difference in curing temperature between the reflecting film and the insulating film can be suppressed.

The manufacturing method of the light-emitting module board of the embodiment includes forming a protecting layer on the wiring pattern formed in a wiring area for electrically connecting the light-emitting components to an external wiring in the non-light-emitting area. In the forming the white film, after the protecting layer is formed, the white insulating film is formed on the protecting layer. That is, in the manufacturing method of the light-emitting module board of the embodiment, since the protecting layer is formed between the wiring pattern and the white insulating film of the wiring area, the protecting layer can suppress the corrosion of the wiring pattern due to the white insulating film.

In the manufacturing method of the light-emitting module board of the embodiment, in forming the protecting layer, the protecting layer is formed of a same component as that of a metal plating formed on the wiring pattern for electrical connection with the plural light-emitting components formed in the light-emitting area. That is, in the manufacturing method of the light-emitting module board of the embodiment, since the protecting layer is made of the same component as the metal plating formed on the wiring pattern, the manufacturing process of forming the protecting layer and the metal plating is sufficient to be performed once.

In the manufacturing method of the light-emitting module board of the embodiment, in forming the protecting layer, in some examples, the protecting layer is formed of a component different from that of a metal plating formed on the wiring pattern for electrical connection with the plural light-emitting components formed in the light-emitting area. That is, in the manufacturing method of the light-emitting module board of the embodiment, the protecting layer of the wiring area can be changed according to the use.

In the manufacturing method of the light-emitting module board of the embodiment, after the white reflecting film is formed in the light-emitting area in the forming the white film, a ceramic coating is applied to the white reflecting film and a thermosetting process is performed to form a new white reflecting film. That is, in the manufacturing method of the light-emitting module board of the embodiment, since the new white reflecting film is formed on the white reflecting film, light from the light-emitting components is diffusely reflected by the two white reflecting films. Accordingly, the light extraction efficiency is improved, and the illumination performance is improved.

In the manufacturing method of the light-emitting module board of the embodiment, the ceramic coating contains at least metal oxide and silicone. As a result, peeling of the white reflecting film can be suppressed.

In the manufacturing method of the light-emitting module board of the embodiment, a metal board and an insulating layer laminated on the metal board are provided. As a result, the board provided with the insulating layer can be provided.

### First Embodiment

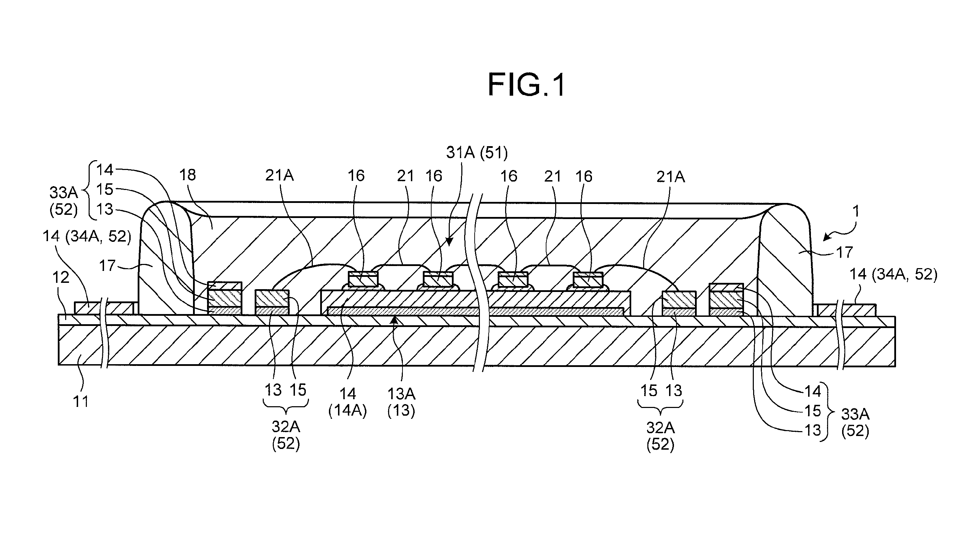

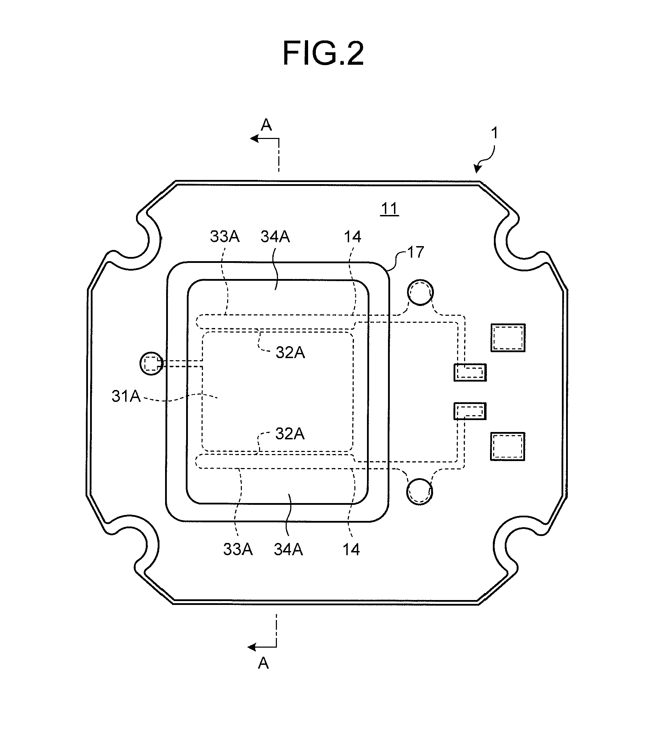

Hereinafter, a light-emitting module board of a first embodiment and a manufacturing method of the light-emitting module board will be described with reference to the drawings. FIG. 1 is a substantially vertical sectional view showing an example of the light-emitting module board of the first embodiment. FIG. 2 is a plan view showing an example of the light-emitting module board. The light-emitting module board 1 shown in FIG. 1 includes a metal board 11, an insulating layer 12, a wiring pattern 13, a white film 14, a gold plating layer 15, an LED chip 16, a reflecting frame 17 and a sealing resin layer 18.

The metal board 11 is formed of, for example, a metal excellent in thermal conductivity and is formed of, for example, aluminum or aluminum alloy. The insulating layer 12 is laminated on the metal board 11, and is formed of, for example, a synthetic resin such as polyimide.

The wiring pattern 13 is formed in such a way that for example, an unnecessary part is removed by etching from a copper layer connected by bonding to the whole surface of the upper surface of the metal board 11. The wiring pattern may have a structure of two or more layers.

The white film 14 is applied onto the metal board 11 by, for example, screen printing. The white film 14 reflects high energy light, which is emitted from the light-emitting element to the metal board side, in a light use direction. The white film 14 is made of, for example, a material containing at least metal oxide and silicone, and is made of ceramic ink in which an organic solvent is changed to raise adhesiveness, and the hardening temperature is raised.

The LED chip 16 emits light. For example, when the LED chip 16 is formed of a blue LED (Light Emitting Diode) chip, the chip is formed such that a semiconductor light-emitting layer and a pair of element electrodes are provided on one surface of a translucent element board made of sapphire. The semiconductor light-emitting layer emits, for example, blue light having a peak wavelength of 455 nm to 465 nm. The blue light is emitted from the semiconductor light-emitting layer not only to the front side as the light use direction, but also to the back side of the light-emitting element through the element board.

Incidentally, the energy intensity of the light emitted to the back side is higher than the energy intensity of the light emitted to the front side. The LED chip 16 is not limited to the blue LED chip, but may be any color LED chip. For example, the LED chip 16 may be an organic EL (Electro Luminescence) element. Alternatively, any light-emitting element may be used instead of the LED chip 16.

The LED chip 16 is mounted on the white film 14 by using a die bonding material (not shown). With respect to the respective adjacent LED chips 16, different polar electrodes of the LED chips 16 are connected to each other through the wiring pattern 13. The die bonding material is, for example, a translucent silicone resin.

The reflecting frame 17 is formed of, for example, a white silicone resin and is formed on the insulating layer 12. For example, the resin in a non-cured state is applied so as to surround the chip mounting area in which the LED chips 16 are mounted and the wiring area, and a curing process is performed, so that the reflecting frame 17 is fixed to surround the chip mounting area and the wiring area.

The sealing resin layer 18 is filled in an area surrounded by the reflecting frame 17. The sealing resin layer 18 is made of a translucent material. The sealing resin layer 18 is formed of, for example, a translucent silicone resin. The sealing resin layer 18 is mixed with, for example, a yellow phosphor in order to obtain a white illumination light.

Besides, the light-emitting module board 1 includes a metal reflecting part 13A using the wiring pattern 13 and the white film 14 provided to cover the metal reflecting part 13A. Although the metal reflecting part 13A has a substantially square shape, no limitation is made to this, and various other shapes may be adopted. The metal reflecting part 13A is connected and fixed to the insulating layer 12, and is formed of, for example, copper. Although the metal reflecting part 13A is formed in the formation process of the wiring pattern 13, the metal reflecting part is not used as the wiring, but is used for improving the reflectivity of outgoing light of the LED chip 16 and as a reinforcing part material.

In this embodiment, a case is exemplified in which the respective LED chips 16 mounted on the white film 14 are connected in series by bonding wires 21. That is, the bonding wires 21 are provided to connect the different polar element electrodes of the LED chips 16 adjacent to each other in the line extension direction. The LED chip 16 arranged at one end of the line of the LED chips 16 and the wiring pattern 13 of the adjacent wiring area are connected by an end bonding wire 21A. The bonding wire 21 and the end bonding wire 21A are formed of, for example, gold or the like.

FIG. 2 is a plan view showing an example of the light-emitting module board 1. The light-emitting module board 1 shown in FIG. 2 includes a chip mounting area 31, a bonding area 32, a wiring area 33 and a resist area 34 when viewed from above the metal board 11. The chip mounting area 31 is an area where a mounting area 31A for mounting the LED chips 16 is arranged. The bonding area 32 is an area where a bonding part 32A electrically connected to the LED chip 16 through the end bonding wire 21A is arranged. The wiring area 33 is an area where a wiring part 33A electrically connected to an external wiring is arranged. The resist area 34 is an area where a resist part 34A for protecting the periphery of the metal board 11 is arranged.

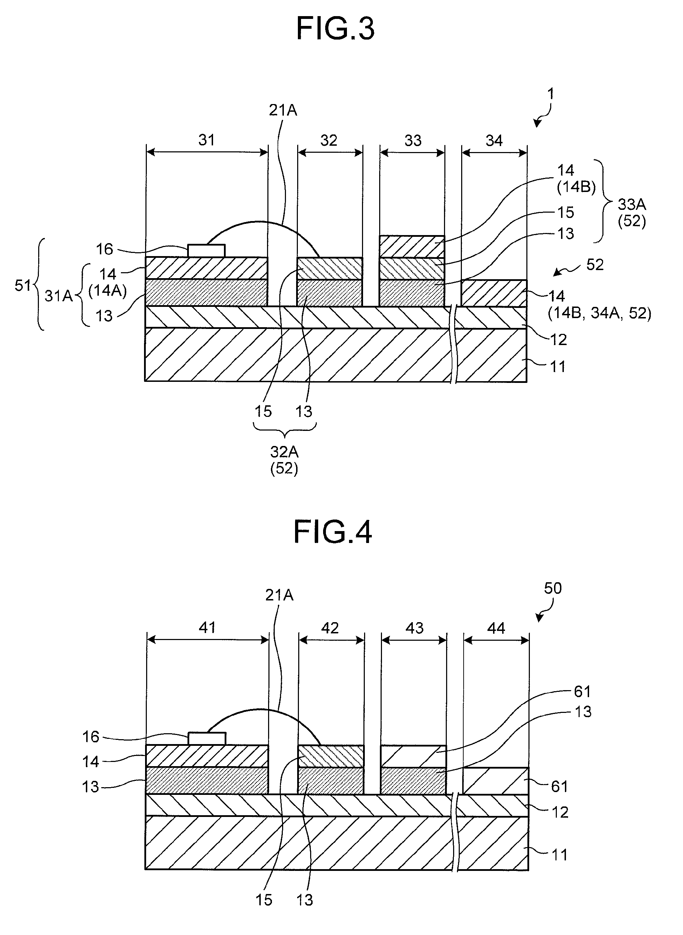

FIG. 3 is a substantially sectional view schematically showing an example of the light-emitting module board 1. The insulating layer 12 is laminated on the metal board 11 shown in FIG. 3. The wiring pattern 13 is formed on the insulating layer 12 of the chip mounting area 31, the bonding area 32 and the wiring area 33. The gold plating layer 15 is formed in the bonding area 32 and the wiring area 33. The wiring pattern 13 and the gold plating layer 15 in the bonding area 32 constitute the bonding part 32A.

The white film 14 as a white reflecting film 14A is formed on the wiring pattern 13 of the chip mounting area 31. The wiring pattern 13 and the white film 14 (white reflecting film 14A) of the chip mounting area 31 constitute the mounting part 31A. The white film 14 as a white insulating film 14B is formed on the gold plating layer 15 of the wiring area 33. The wiring pattern 13, the gold plating layer 15 and the white film 14 (white insulating film 14B) of the wiring area 33 constitute the wiring part 33A. The white film 14 as the white insulating film 14B is formed on the insulating layer 12 of the resist area 34. The white film 14 (white insulating film 14B) of the resist area 34 constitutes the resist part 34A. The LED chip 16 is mounted on the white film 14 of the mounting part 31A of the chip mounting area 31. The LED chip 16 and the gold plating layer 15 of the bonding part 32A are electrically connected by the end bonding wire 21A. As a result, the mounting part 31A including the white film 14 (white reflecting film 14A) and the LED chip 16 constitute a light-emitting part 51. Incidentally, an area other than the light-emitting part 51 is a non-light-emitting part 52. The non-light-emitting part 52 is an area other than the light-emitting part 51, and is, for example, the bonding part 32A, the wiring part 33A and the resist part 34A.

Next, in the light-emitting module board 1 shown in FIG. 3, the reason why the white insulating film 14B is formed on the insulating layer 12 of the resist area 34, and the gold plating layer 15 is arranged between the wiring patter 13 and the white insulating film 14B of the wiring area 33 will be described. FIG. 4 is a substantially sectional view schematically showing reference example 1 of a light-emitting module board. Incidentally, the same components as those of the light-emitting module board 1 shown in FIG. 3 are denoted by the same reference numerals and the description of the duplicate components and processes will be omitted. In a light-emitting module board 50 shown in FIG. 4, a white resist film 61 is formed on an insulating layer 12 of a resist area 44, and a white resist film 61 is formed on a wiring pattern 13 of a wiring area 43. Further, in order to prevent peeling of a white reflecting film of a mounting part 41A of a chip mounting area 41, a white film 14 is formed on a wiring pattern 13 of the chip mounting area 41. However, the white film 14 is made of a ceramic ink in which an organic solvent is changed in order to raise the adhesiveness, the heat resistance is high, and the curing temperature is as high as approximately 190°C. On the other hand, the white resist film 61 is required to have high denseness, is a ceramic ink containing silica and titanium as its main ingredients, and includes a general organic solvent. Thus, the heat resistance thereof is low and the curing temperature is as low as approximately 150°C.

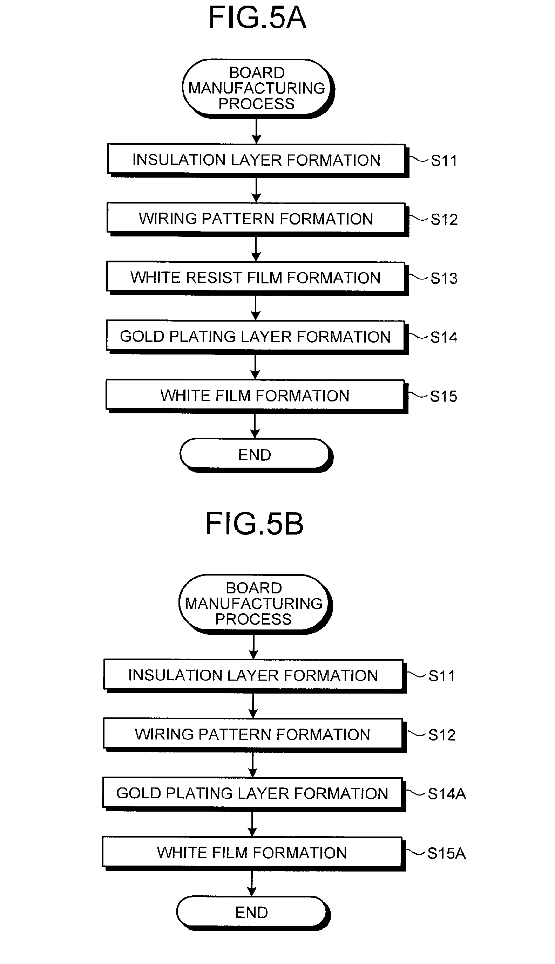

FIG. 5A is a flowchart showing an example of a board manufacturing process of the light-emitting module board 50 of reference example 1 of FIG. 4. In the board manufacturing process shown in FIG. 5A, a manufacturing apparatus laminates the insulating layer 12 on the metal board 11 (Act 11). Further, in the board manufacturing process, the manufacturing apparatus forms the wiring pattern on the insulating layer 12 (Act 12). Further, in the board manufacturing process, the manufacturing apparatus forms the white resist film 61 on the wiring pattern 13 of the wiring area 43 and the resist area 44 (Act 13). The curing temperature in a thermosetting process when the white resist film 61 is formed is approximately 150°C as stated above.

Further, in the board manufacturing process, the manufacturing apparatus forms the gold plating layer 15 on the wiring pattern 13 of the bonding area 42 (Act 14). Further, in the board manufacturing process, the manufacturing apparatus forms the white film 14 on the wiring pattern 13 of the chip mounting area 41 (Act 15), and the manufacturing process is ended. However, since the curing temperature in the thermosetting process when the white film 14 is formed is about 190°C, the white resist film 61 formed at Act 13 is degraded.

Then, in a method of manufacturing the light-emitting module board 1 shown in FIG. 3, the highly reflective white film 14 of the material having the same curing temperature is formed on the wiring pattern 13 of the chip mounting area 31, the wiring pattern 13 of the wiring area 33 and the insulating layer 12 of the resist area 34. FIG. 5B is a flowchart showing an example of a board manufacturing process of the light-emitting module board 1 of FIG. 3. In the board manufacturing process shown in FIG. 5B, after performing the process of Act 11 and Act 12, the manufacturing apparatus forms the gold plating layer 15 on the wiring pattern 13 of the bonding area 32 and the wiring area 33 (Act 14A). In the board manufacturing process shown in FIG. 5B, the manufacturing apparatus does not perform the process of forming the white resist film 61.

Further, in the board manufacturing process, after forming the gold plating layer 15 on the wiring pattern 13 of the bonding area 32 and the wiring area 33 at Act 14A, the manufacturing apparatus forms the white film 14 on the wiring pattern 13 of the chip mounting area 31, the gold plating layer 15 of the wiring area 33, and the insulating layer 12 of the resist area 34 (Act 15A). The white film 14 on the wiring pattern 13 of the chip mounting area 31 is the white reflecting film 14A as the highly reflective film, and the white film 14 on the gold plating layer 15 of the wiring area 33 and the insulating layer 12 of the resist area 34 is the white insulating film 14B as a solder resist.

The curing temperature of the thermosetting process of forming the white film 14 is about 190°C. However, in the forming process of the white film 14, even when the thermosetting process of 190°C is performed, since the white resist film 61 is not provided like the light-emitting module board 50 of FIG. 4, the degradation of the white resist film 61 can be prevented. Further, the white film 14 (white insulating film 14B) is formed in the wiring part 33A of the wiring area 33 instead of the white resist film 61, and the denseness of the white film 14 is lower than the white resist film 61. However, since the manufacturing apparatus arranges the gold plating layer 15 between the wiring pattern 13 and the white insulating film 14B of the wiring area 33, corrosion of the wiring pattern 13 due to reduction in the denseness of the white film 14 can be suppressed.

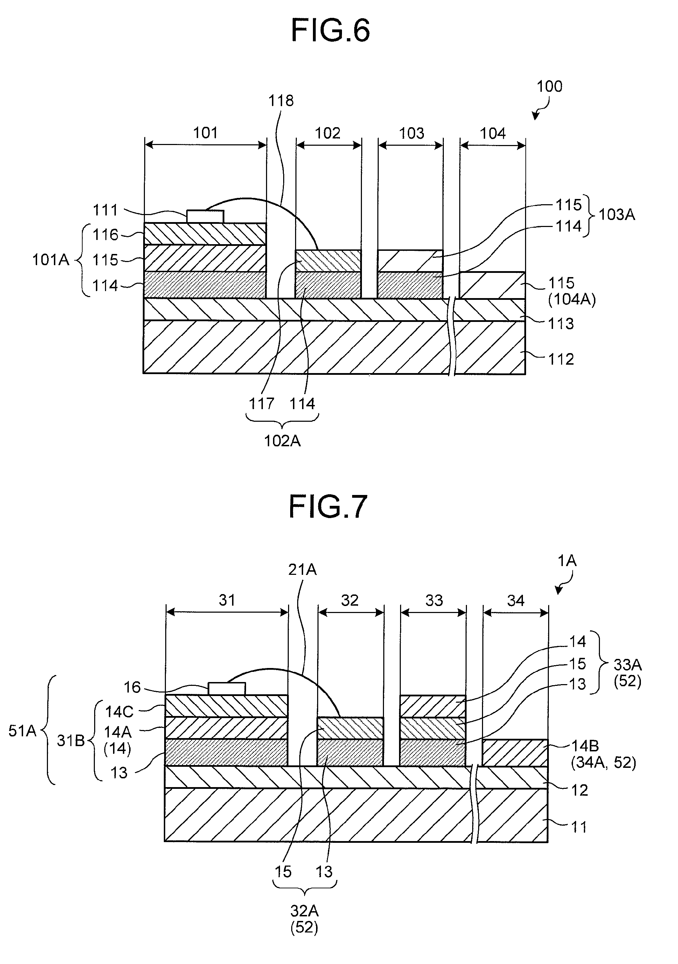

FIG. 6 is an explanatory view schematically showing reference example 2 of a light-emitting module board. A light-emitting module board 100 shown in FIG. 6 includes a chip mounting area 101, a bonding area 102, a wiring area 103 and a resist area 104.

The chip mounting area 101 is an area where a mounting part 101A for mounting an LED chip 111 is arranged. The bonding area 102 is an area where a bonding part 102A electrically connected to the LED chip 111 through a bonding wire 118 is arranged. The wiring area 103 is an area where a wiring part 103A in which an electric wiring is arranged is arranged. The resist area 104 is an area where a resist part 104A for protecting the periphery of the light-emitting module board 100 is arranged.

The lamination of the light-emitting module board 100 shown in FIG. 6 includes a metal board 112, an insulating layer 113, a copper wiring pattern 114, a resist layer 115, a ceramic ink film 116, a gold plating layer 117 and the LED chip 111. The ceramic ink film 116 is a highly reflective white film.

The insulating layer 113 is formed on the metal board 112. The copper wiring pattern 114 is formed on the insulating layer 113 of the chip mounting area 101, the bonding area 102 and the wiring area 103. The resist layer 115 is formed on the insulating layer 113 of the resist area 104. The resist layer 115 is formed on the copper wiring pattern 114 of the chip mounting area 101 and the wiring area 103. The copper wiring pattern 114 and the resist layer 115 of the wiring area 103 constitute the wiring part 103A. The resist layer 115 of the resist area 104 constitutes the resist part 104A.

The gold plating layer 117 is formed on the copper wiring pattern 114 of the bonding area 102. The copper wiring pattern 114 and the gold plating layer 117 of the bonding area 102 constitute the bonding part 102A. The ceramic ink film 116 is formed on the resist layer 115 of the chip mounting area 101. The copper wiring pattern 114, the resist layer 115 and the ceramic ink film 116 of the chip mounting area 101 constitute the mounting part 101A. The LED chip 111 is mounted on the ceramic ink film 116 of the mounting part 101A. Further, the LED chip 111 and the gold plating layer 117 are electrically connected through the bonding wire 118.

In the light-emitting module board 100, since the ceramic ink film 116 is formed on the resist layer 115 of the mounting part 101A of the chip mounting area 101, high reflective performance is obtained. However, in the light-emitting module board 100 of reference example 2, the ceramic ink film 116 formed on the resist layer 115 of the mounting area 101 can peel.

On the other hand, the light-emitting module board 1 of the first embodiment includes the board, the light-emitting part 51 and the white insulating film 14B. The light-emitting part 51 includes the plural LED chips 16 mounted on the board, and the white reflecting film 14A of the ceramic coating formed in the light-emitting area (chip mounting area 31) on the board on which the plural LED chips 16 are mounted. Further, the white insulating film 14B is made of the same material as the white reflecting film 14A and is formed in the non-light-emitting part 52 which is other than the light-emitting part 51 and is provided on the board outside the light-emitting part 51. As a result, in the light-emitting module board 1, the white film 14 of the ceramic coating is used, so that peeling of the white reflecting film in the chip mounting area 31 can be prevented. Further, not only the light-emitting part 51 but also the light-emitting module board 1 can be easily formed.

The light-emitting module board 1 of the first embodiment includes the white reflecting film 14A as the white film 14 of the ceramic coating of the light-emitting part 51 on the board, and the white insulating film 14B formed in non-light-emitting part 52 on the board and having the same material as the white reflecting film 14A. As a result, in the light-emitting module board 1, the white film 14 of the ceramic coating is used, so that peeling of the white reflecting film in the chip mounting area 31 can be prevented. Further, degradation of the insulating film as the solder resist of the non-light-emitting part 52 due to a difference in curing temperature between the reflecting film and the insulating film can be suppressed.

In the light-emitting module board 1 of the first embodiment and in the non-light-emitting part 52, the gold plating layer 15 as the protecting layer is formed on the wiring pattern 13 formed in the wiring area 33 for electrically connecting the LED chip 16 to an external wiring. As a result, in the light-emitting module board 1, since the gold plating layer 15 is arranged between the wiring pattern 13 and the white insulating film 14B of the wiring area 33, the gold plating layer 15 can suppress the corrosion of the wiring pattern 13 due to the white insulating film 14B. Further, since the gold plating layer 15 is arranged, reduction in light flux density of the LED chip 16 due to reduction in reflectivity can be suppressed.

In the light-emitting module board 1 of the first embodiment, the gold plating layer 15 used in the wiring part 33A of the wiring area 33 is made to have the same component as the gold plating layer 15 used in the bonding part 32A and formed on the wiring pattern 13 for electrical connection with the plural LED chips 16 of the light-emitting part 51. Thus, the manufacturing process of forming the gold plating layer 15 is sufficient to be performed once.

Incidentally, in the first embodiment, although the gold plating layers 15 used in the bonding part 32A and the wiring part 33A are formed of the same component, the gold plating layers 15 of the bonding part 32A and the wiring part 33A may be formed by using gold platings of different components. Besides, in the first embodiment, although the gold plating layer 15 is exemplified, for example, a metal plating layer of nickel or silver may be used, and the layer can be appropriately changed.

In the manufacturing method of the first embodiment, the white reflecting film 14A of the light-emitting part 51 on the board and the white insulating film 14B of the non-light-emitting part 52 on the board are formed in the same process and by using the same white film 14. As a result, degradation of the insulating film as the solder resist due to a difference in curing temperature between the white reflecting film and the white insulating film can be suppressed.

In the manufacturing method of the first embodiment, when the gold plating layer 15 is formed between the wiring pattern 13 and the white insulating film 14B in the wiring part 33A of the wiring area 33, the layer is formed of the same component as the gold plating layer 15 in the bonding part 32A of the bonding area 32. As a result, the processing process is sufficient to be performed once.

In the light-emitting module board 1 of the first embodiment, since the plural LED chips 16 are mounted on the white reflecting film 14A, the high energy light emitted from the LED chips 16 to the back side can be reflected in the light use direction. The reflecting surface of the white reflecting film 14A can reflect a light component in a low wavelength region as compared with no white reflecting film 14A, and by that, excellent light reflecting performance can be realized as compared with no white reflecting film 14A. Incidentally, it is conceivable that part of the high energy light is transmitted through the white reflecting film 14A. The transmitted light transmitted through the white reflecting film 14A is incident on the white reflecting film 14A and is reflected in the light use direction by the white reflecting film. As a result, primary and secondary reflection occurs, and the reflecting performance of the light emitted to the back side of the LED chip 16 can be improved. In other words, the light extraction performance is improved, and the light emission efficiency of the light-emitting module can be improved.

Incidentally, in the light-emitting module board 1 of the first embodiment, although the mounting part 31A in the mounting area 31 is constructed of the wiring pattern 13 and the white reflecting film 14A, a new white reflecting film may be formed on the white reflecting film 14A, and an embodiment in this case will be described below.

### Second Embodiment

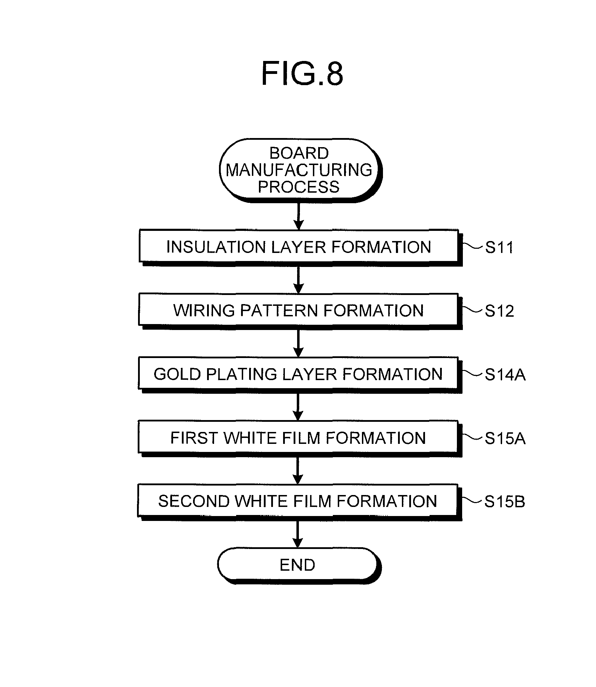

FIG. 7 is a substantially sectional view schematically showing an example of a light-emitting module board of a second embodiment. FIG. 8 is a flowchart showing an example of a board manufacturing process of the light-emitting module board 1A of FIG. 7. Incidentally, the same components as the light-emitting module board 1 of the first embodiment are denoted by the same reference numerals and the description of the duplicate components and processes will be omitted.

A mounting part 31B of the light-emitting module board 1A shown in FIG. 7 includes a wiring pattern 13, a first white reflecting film 14A and a second white reflecting film 14C. Then, an LED chip 16 is mounted on the mounting part 31B so that a light-emitting part 51A is constructed. Although the second white reflecting film 14C has the same component as the first white reflecting film 14A, the second white reflecting film 14C is formed on the first white reflecting film 14A in a separate process.

In the board manufacturing process shown in FIG. 8, after performing the process of Act 11 and Act 12, the manufacturing apparatus forms a gold plating layer 15 on a wiring pattern 13 of a bonding area 32 and a wiring area 33 (Act 14A).

Further, in the board manufacturing process, after forming the gold plating layer 15 on the wiring pattern 13 of the bonding area 32 and the wiring area 33 at Act 14A, the manufacturing apparatus performs a first white film process of forming a white film 14 on the wiring pattern 13 of the chip mounting area 31, the gold plating layer 15 of the wiring area 33, and an insulating layer 12 of a resist area 34 (Act 15A). As a result, the first white reflecting film 14A as a high reflecting film is formed on the wiring pattern 13 of the chip mounting area 31. Besides, a white insulating film 14B as a solder resist is formed on the gold plating layer 15 of the wiring area 33 and the insulating layer 12 of the resist area 34.

Further, in the board manufacturing process, the manufacturing apparatus performs a second white film process of forming a white film 14 on the first white reflecting film 14A of the chip mounting area 31 (Act 15B). As a result, the second white reflecting film 14C is formed on the first white reflecting film 14A of the chip mounting area 31. That is, since light from the LED chip 16 is diffusely reflected by the first white reflecting film 14A and the second white reflecting film 14C, the light extraction efficiency is improved, and further, the illumination performance is improved.

In the second embodiment, the second white reflecting film 14C is formed on the first white reflecting film 14A of the chip mounting area 31. As a result, since the light from the LED chip 16 is diffusely reflected by the first white reflecting film 14A and the second white reflecting film 14C, the light extraction efficiency is improved, and further, the illumination performance is improved.

Incidentally, in the second embodiment, the second white reflecting film is made as thin as possible, and even if the film thickness is made, for example, about 0.01 mm, sufficient reflecting performance can be realized.

A light source apparatus can be easily constructed by providing the light-emitting module board 1 (1A) of the embodiment, and a lighting device (not shown) to supply power to the LED chip 16 of the light-emitting module board 1 (1A). The light source apparatus can be easily constructed by using the light emitting module board 1 (1A).

Although the example embodiments have been described, these embodiments have been presented by way of example only, and are not intended to limit the scope of the invention. Indeed, these embodiments can be carried out in a variety of other forms, and various omissions, substitutions and changes can be made within the scope and without departing from the spirit of the invention. These embodiments and modifications thereof fall within the scope and spirit of the invention and fall within the scope of the invention recited in the claims and their equivalents.

## Claims

1. A light-emitting module board (1) comprising:
a board (11);
a light-emitting part (51) including a plurality of light-emitting components (16) mounted on the board (11);
a white reflecting film (14A) of a ceramic coating formed in a light-emitting area of the board (11) and on which the plurality of light-emitting components (16) are mounted; and
a white insulating film (14B) made of a same material as the white reflecting film (14A) and formed in a non-light-emitting area of the board and outside the light-emitting part (51).

2. The light-emitting module board of claim 1, further comprising
a wiring pattern (13) formed in the light-emitting area and the non-light-emitting area, and
a protecting layer (15) formed in the non-light-emitting area and in a wiring area (33) configured for electrically connecting the light-emitting components (16) to an external wiring.

3. The light-emitting module board of claim 2, wherein the protecting layer (15) formed in the wiring area (33) is made of a same component as that of a metal plating (15) formed on the wiring pattern (13) for electrical connection with the plurality of light-emitting components (16) formed in the light-emitting area.

4. The light-emitting module board of claim 2, wherein the protecting layer (15) formed in the wiring area (33) is made of a component different from that of a metal plating (15) formed on the wiring pattern (13) for electrical connection with the plurality of light-emitting components (16) formed in the light-emitting area.

5. The light-emitting module board (1A) of any one of claims 1 to 4, wherein
the white reflecting film (14) formed in the light-emitting area includes a first white reflecting film (14A) and a second white reflecting film (14C) formed on the first white reflecting film.

6. The light-emitting module board of any one of claims 1 to 5, wherein
the ceramic coating contains at least metal oxide and silicone.

7. The light-emitting module board of any one of claims 1 to 6, wherein the board (11) includes a metal board (11) and an insulating layer (12) laminated on the metal board (11).

8. A light source apparatus comprising:
a light-emitting module board of any one of claims 1 to 7; and
a lighting device to supply power to the light-emitting components of the light-emitting module board.

9. A method of manufacturing a light-emitting module board comprising:
forming a wiring pattern (13) on a board (11); and
forming a white reflecting film (14A) in a light-emitting area and forming a white insulating film (14B) in a non-light-emitting area by applying a ceramic coating to the light-emitting area on the board (11) on which a plurality of light-emitting components (16) are mounted and to the non-light-emitting area on the board (11) outside the light-emitting area and by performing a thermosetting process.

10. The method of claim 9,further comprising forming a protecting layer (15) on the wiring pattern (13) formed in a wiring area (33) configured for electrically connecting the light-emitting components (16) to an external wiring in the non-light-emitting area, wherein
after the protecting layer (15) is formed in the forming the protecting layer, the white insulating film (14B) is formed on the protecting layer (15).

11. The method of claim 10, wherein the protecting layer (15) is formed of a same component as that of a metal plating formed on the wiring pattern (13) for electrical connection with the plurality of light-emitting components (16) formed in the light-emitting area.

12. The method of claim 10, wherein the protecting layer (15) is formed of a component different from that of a metal plating (15) formed on the wiring pattern (13) for electrical connection with the plurality of light-emitting components (16) formed in the light-emitting area.

13. The method of claim 9, wherein after the white reflecting film (14A) is formed in the light-emitting area, another ceramic coating is applied to the white reflecting film (14A) and a thermosetting process is performed to form a new white reflecting film (14C).

14. The method of any one of claims 9 to 13, wherein the ceramic coating contains at least metal oxide and silicone.

15. The method of any one of claims 9 to 14, further comprising
forming a substrate by laminating an insulating layer (12) on a metal board (11).
